(19)

**Europäisches Patentamt**
**European Patent Office**
**Office européen des brevets**

(11) **EP 4 589 652 A2**

(12) **EUROPEAN PATENT APPLICATION**

(43) Date of publication:
**23.07.2025 Bulletin 2025/30**

(21) Application number: **25158664.0**

(22) Date of filing: **27.04.2021**

(51) International Patent Classification (IPC):
**H01L 23/31** (2006.01)   **H01L 23/367** (2006.01)
**H01L 23/40** (2006.01)   **H01L 23/051** (2006.01)
**H01L 23/36** (2006.01)   **H02P 1/42** (2006.01)
**H02P 1/46** (2006.01)

(52) Cooperative Patent Classification (CPC):
**H01L 23/36; H01L 23/051;** H02P 1/42; H02P 1/46;
H10D 18/00

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.04.2020   CN 202010355028**

(62) Document number(s) of the earlier application(s) in accordance with Art. 76 EPC:
**21797625.7 / 4 145 502**

(71) Applicant: **Zhuzhou CRRC Times Semiconductor Co., Ltd.**
**Zhuzhou, Hunan 412005 (CN)**

(72) Inventors:
• **Guo, Jintong**
  **Zhuzhou, Hunan, 412005 (CN)**
• **Cao, Guohong**
  **Zhuzhou, Hunan, 412005 (CN)**
• **Zeng, Wenbin**
  **Zhuzhou, Hunan, 412005 (CN)**

• **Sun, Wenwei**
  **Zhuzhou, Hunan, 412005 (CN)**
• **Liu, Ying**
  **Zhuzhou, Hunan, 412005 (CN)**
• **Dong, Chao**
  **Zhuzhou, Hunan, 412005 (CN)**
• **Deng, Chao**
  **Zhuzhou, Hunan, 412005 (CN)**
• **Chen, Benlong**
  **Zhuzhou, Hunan, 412005 (CN)**
• **Tang, Bao**
  **Zhuzhou, Hunan, 412005 (CN)**

(74) Representative: **Petraz, Gilberto Luigi et al**
**GLP S.r.l.**
**Viale Europa Unita, 171**
**33100 Udine (IT)**

Remarks:
This application was filed on 18-02-2025 as a divisional application to the application mentioned under INID code 62.

(54) **THYRISTOR ELEMENT, THYRISTOR ELEMENT ASSEMBLY STRUCTURE AND SOFT STARTER**

(57)    A thyristor element assembly structure comprises a first radiator (50), a second radiator (70) and a thyristor element (5) sandwiched between the first radiator and the second radiator, wherein the thyristor element (5) is connected with the first radiator (50) and the second radiator (70) that are on both sides of the thyristor element by means of a plurality of insulating fasteners (10), the thyristor element (5) comprises a gate assembly (80) and a chip packaging assembly (60), the chip packaging assembly (60) comprises a first packaging shell (606) and a second packaging shell (601), the first packaging shell and the second packaging shell enclose a packaging cavity, the second packaging shell (601) is provided with a blind hole (608) which is at least partially and fixedly connected to the gate assembly, side walls of the blind hole (608) serve as a portion of cavity walls of the packaging cavity, and the gate assembly (80) is fixedly engaged to the blind hole (608) of the chip packaging assembly.

Fig. 9

## Description

## Field of the Invention

The present invention relates to the technical field of the soft start of electric motors, and in particular to a thyristor element, a thyristor element assembly structure and a soft starter.

## Background of the Invention

When an electric motor is soft started, an output voltage of a thyristor in a soft starter gradually increases and the electric motor gradually accelerates until the thyristor is completely turned on and the voltage of the electric motor reaches a rated working voltage, and thus, the smooth start of the electric motor is realized, and the tripping upon a start current can be avoided.

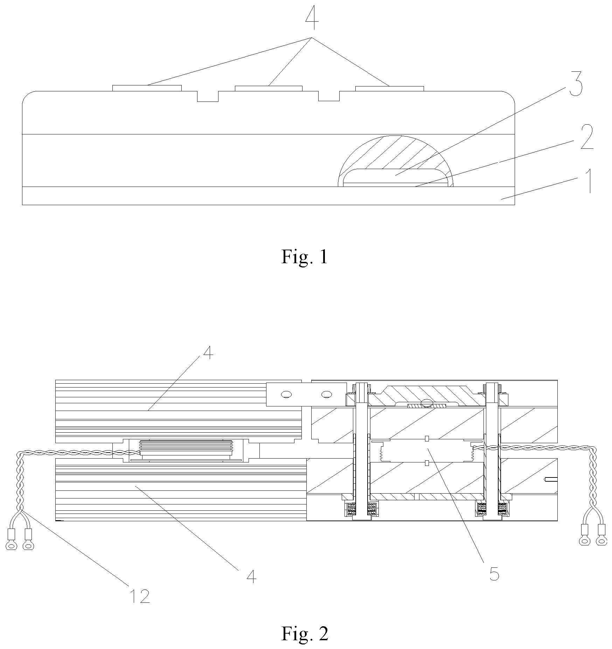

An electric motor, the power of which is lower than 100 kW, generally uses a thyristor element assembly structure of single-sided radiation as shown in Fig. 1 when being soft started. The thyristor element assembly structure includes a metal bottom plate 1, an insulating heat conduction plate 2, a silicon chip 3, and radiators 4 located on one side of the silicon chip 3. Since the radiation capability of the thyristor element assembly structure is limited, it cannot assist an electric motor, the power of which is greater than 100 kW, in soft start.

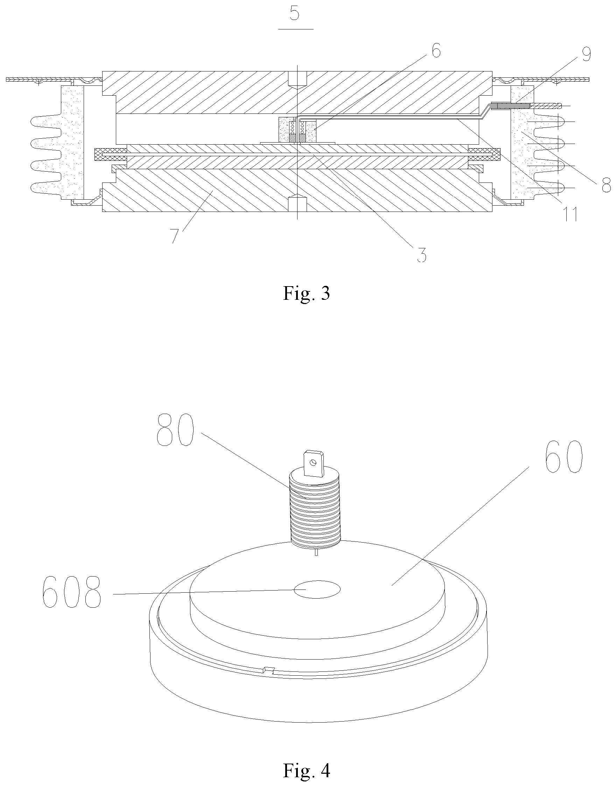

The electric motor, the power of which is greater than 100 kW, generally uses, for example, a thyristor element assembly structure as shown in Fig. 2, when being soft started. Such thyristor element assembly structure includes two radiators respectively located on two sides of a thyristor element 5, thereby improving the radiation capability thereof. Fig. 3 shows a cross-sectional schematic diagram of the thyristor element 5 in Fig. 2.

In the existing technique, as shown in Fig. 3, a gate assembly 6 of the thyristor element 5 is packaged inside a chip packaging assembly 7 thereof, and the use of a lead sleeve 9 penetrating a ceramic side wall 8 is required to connect an inner lead 11 and an outer lead 12, in order to connect a chip gate of a thyristor chip and the outside, where the outer lead 12 and the lead sleeve 9 need to be welded for connection. The anti-fatigue capability of welding is relatively weak, which is inconducive to the prolonging of the service life of the thyristor element 5. In addition, the thyristor element 5 in the existing technique is complex in structure, difficult in assembly process and high in production cost, which is inconducive to the promotion and application of the thyristor element 5.

## Summary of the Invention

With respect to the above-mentioned problems in the existing technique, the present application provides a thyristor element, a thyristor element assembly structure and a soft starter. A new gate assembly is used rather than welding, which is conducive to the prolonging of the service life of the thyristor element. Moreover, the structure of the thyristor element is simplified, and the difficulty of an assembly process thereof and the production cost thereof are reduced, which is conducive to the promotion and application of the thyristor element.

The present invention provides a thyristor element, a thyristor element assembly structure and a soft starter. The thyristor element includes a gate assembly and a chip packaging assembly. The chip packaging assembly is provided with a blind hole which is at least partially and fixedly connected to the gate assembly. The axis of the blind hole is perpendicular to a chip in the chip packaging assembly. The gate assembly includes a gate needle extending from the interior of the gate assembly and abutting against a chip gate of the chip; and a lug plate extending out of the top of the gate assembly and configured for connecting the gate needle and a lead. By the use of the thyristor element, welding can be avoided, and the lead can also be avoided from penetrating a side wall of the chip packaging assembly, which is conducive to the prolonging of the service life of the thyristor element, and conducive to the reduction of the production cost of the thyristor element, and also conducive to the decrease of the volume of the thyristor element.

In one implementation of a first aspect, the gate assembly includes: the gate needle including a needle body and an elastic member, which are integrally formed, with the needle body abutting against the chip gate; the lug plate, a first end of which is embedded into the elastic member, and a second end of which is provided with a through-hole for fixing the lead; a first gate member, where the needle body passes through the first gate member to abut against the chip gate; and a second gate member sleeved outside the first gate member and fixedly engaged in the blind hole of the chip packaging assembly so as to fixedly engage the gate assembly and the chip packaging assembly. The gate assembly in the implementation has the advantages of a simple manufacturing process, a long service life, stable performance, a low cost, etc., which is conducive to the promotion and application of the gate assembly.

In one implementation of the first aspect, an outer wall of the second gate member is at least partially connected to threads on a side wall of the blind hole of the chip packaging assembly. Through the implementation, the gate assembly and the chip packaging assembly can be fixedly connected conveniently.

In one implementation of the first aspect, the second gate member and the first gate member are in interference fit to form a cavity that accommodates the elastic member in a compressed state, and the lug plate passes through the second gate member to be connected to the gate needle. Through the implementation, the gate needle abuts against the chip gate, thereby facilitating the stable transmission of a signal.

In one implementation of the first aspect, the diameter of the cavity is greater than the diameter of the elastic member of 0.1mm to 0.3 mm. Through the implementation, the elastic member not being bent and deformed during a compression process can be ensured, which is conducive to the stable transmission of a signal.

In one implementation of the first aspect, the blind hole is located in the middle part of the chip packaging assembly. Through the implementation, uniform stress distribution is facilitated, and a local fatigue failure is avoided, thereby facilitating prolonging the service life of the thyristor element.

In one implementation of the first aspect, the chip packaging assembly includes a first packaging shell and a second packaging shell. The first packaging shell and the second packaging shell enclose a packaging cavity, and an anode molybdenum sheet, the chip, a cathode molybdenum sheet and a silver gasket are sequentially stacked in the packaging cavity, where the anode molybdenum sheet is in contact with the first packaging shell, and the silver gasket is contact with the second packaging shell. The gate needle passes through through-holes in the silver gasket and the cathode molybdenum sheet to abut against the chip gate. The chip packaging assembly in the implementation has the advantages of a simple manufacturing process, a long service life, stable performance, a low cost and the like, which is conducive to the promotion and application of the chip packaging assembly.

In one implementation of the first aspect, the first packaging shell includes an anode copper block and an anode plastic shell surrounding the anode copper block, and the second packaging shell includes a cathode copper block and a cathode plastic shell surrounding the cathode copper block, with the blind hole being provided in the middle part of the cathode copper block. Through the implementation, the reduction of the weight of the thyristor element is facilitated, and the reduction of a sealing cost is also facilitated.

In one implementation of the first aspect, the first packaging shell and the second packaging shell are both formed by using metal insert injection molding process.

In one implementation of the first aspect, the chip packaging assembly packages the chip by using a solid sealing dielectric, and the first packaging shell is provided with a glue injection opening. Through the implementation, since the solid sealing dielectric is used, the cost of the thyristor element can be greatly reduced compared with nitrogen filling being used.

In one implementation of the first aspect, the solid sealing dielectric is silica gel. Through the implementation, the packaging cost can be further reduced.

In one implementation of the first aspect, when the silica gel is liquid, the viscosity thereof is between 500 mPa s and 800 mPa·s; and after the silica gel is cured, the dielectric strength thereof is 12 kV/mm.

In a second aspect, the present invention further provides a thyristor element assembly structure, the thyristor element assembly structure including a first radiator, a second radiator and the above-mentioned thyristor element sandwiched between the first radiator and the second radiator. Through the implementation, the use of welding is not required, and the lead does not need to penetrate the side wall of the chip packaging assembly, which is conducive to the prolonging of the service life of the thyristor element, and conducive to the reduction of the production cost of the thyristor element, and also conducive to the decrease of the volume of the thyristor element.

In one implementation of the second aspect, the first radiator and the second radiator are fixedly connected by means of four insulating fasteners, with the insulating fastener including: a screw rod, which passes through the first radiator to be in a threaded fit with a threaded hole of the second radiator; an insulating sleeve sleeved on the screw rod; a disc spring group sleeved outside the insulating sleeve and located between the first radiator and the insulating sleeve; and gaskets sleeved on the insulating sleeve and arranged at two ends of the disc spring group. Through the implementation, the use of a leveling apparatus can be avoided, and the uniform pressure distribution can be ensured. In addition, the insulating fastener in the implementation can ensure that the first radiator and the second radiator are in an electrical isolation state while fixing the first radiator and the second radiator, thereby avoiding the occurrence of a short circuit.

In one implementation of the second aspect, the insulating sleeve is an integrated sleeve, the insulating sleeve includes a first sleeve body and a second sleeve body, which are in communication with each other, the diameter of the first sleeve body is greater than the diameter of the second sleeve body, the first sleeve body is configured for accommodating the head part of the screw rod, and the second sleeve body is configured for accommodating part of a main body of the screw rod and extends from the first radiator to the second radiator. Through the implementation, a soft starter that uses an integrated sleeve can withstand a voltage up to 6500 V.

In one implementation of the second aspect, the insulating sleeve includes a first sleeve body and a second sleeve body, which are separated from each other, the first sleeve body is located between the main body of the screw rod and the first radiator, and the second sleeve body is located between the main body of the screw rod and the second radiator. Through the implementation, the cost of the insulating fastener can be saved.

In one implementation of the second aspect, the insulating sleeve is made of a material the comparative tracking index of which is less than or equal to 400. Through the implementation, it is conducive to ensure the safe use of the thyristor element assembly structure.

In one implementation of the second aspect, the thyristor element assembly structure includes two thyristor elements, which are connected in antiparallel, and two first radiators, which correspond to the thyristor elements on a one-to-one basis. Through the implementation, the two radiators, as whole, play a role in connecting the two thyristor elements, and antiparallel connection can be realized without needing to use an external copper busbar for connection, such that the material cost and the volume of the thyristor element assembly structure can be reduced, so as to facilitate the miniaturization of the soft starter, thereby improving the market competitiveness of the soft starter.

In one implementation of the second aspect, the two first radiators form an integral radiator by means of a stress separator groove provided therebetween. Through the implementation, it is conducive to avoiding pressure interference.

In one implementation of the second aspect, the first radiator includes first base bodies and a plurality of first fins, with the stress separator groove being provided between two first base bodies; and the second radiator includes second base bodies and a plurality of second fins. Through the implementation, it is conducive to improving the radiation capability of a radiator.

In a third aspect, the present invention further provides a soft starter, the soft starter including the above-mentioned thyristor element assembly structure. Through the implementation, the soft starter uses a thyristor element assembly structure that has the above-mentioned thyristor element, and the use of welding is not required and a lead does not need to penetrate a side wall of a chip packaging assembly, which is conducive to prolonging the service life of the soft starter, conducive to reducing the production cost of the soft starter, also conducive to the miniaturization of the soft starter, and thus conducive to the soft starter gaining market approbation.

Compared with the existing technique, the thyristor element, the thyristor element assembly structure and the soft starter provided in the present application have the following beneficial effects.

1. Since it is unnecessary to use a welding connection structure that has relatively weak anti-fatigue capability, the structural unsteadiness caused by welding can be avoided, which is conducive to prolonging the service life of the soft starter.
2. Since it is unnecessary to use a lead to penetrate a ceramic side wall of the chip packaging assembly, the reduction of the production cost of the soft starter is facilitated.
3. The thyristor element in the present invention is simple in structure, easy in assembly process and low in production cost, which is conducive to promotion and application.
4. Since a solid sealing dielectric is used, the cost of the thyristor element can be greatly reduced compared with nitrogen filling being used.

The above-mentioned features can be combined in any suitable manner or be replaced by equivalent features, as long as the objective of the present invention can be achieved.

## Brief Description of the Drawings

The invention will be described in more details below on the basis of embodiments and with reference to the accompanying drawings.

Fig. 1 shows a cross-sectional schematic diagram of a thyristor element assembly structure according to the existing technique;
Fig. 2 shows a cross-sectional schematic diagram of another thyristor element assembly structure according to the existing technique;
Fig. 3 shows a cross-sectional schematic diagram of a thyristor element in Fig. 2;
Fig. 4 shows an exploded schematic diagram of a thyristor element according to one implementation of the invention;
Fig. 5 shows a perspective schematic diagram of a thyristor element according to one implementation of the invention;
Fig. 6 is a structural schematic diagram of a gate assembly according to one implementation of the invention;
Fig. 7 shows a cross-sectional schematic diagram of a gate assembly according to one implementation of the invention;
Fig. 8 shows a cross-sectional schematic diagram of a thyristor element according to one implementation of the invention;
Fig. 9 shows a perspective schematic diagram of a thyristor element according to one implementation of the invention;
Fig. 10 shows a cross-sectional schematic diagram of a thyristor element according to one implementation of the invention;
Fig. 11 shows a cross-sectional schematic diagram of an insulating fastener according to one implementation of the invention;
Fig. 12 shows a cross-sectional schematic diagram of a thyristor element assembly structure according to one implementation of the invention, with a lead being shown in the figure;
Fig. 13 is a partially enlarged view of region A in Fig. 12; and
Fig. 14 shows a circuit topology graph of a thyristor element assembly structure according to one implementation of the invention.

List of reference signs:

1-metal bottom plate; 2-insulating heat conduction plate; 3-silicon chip; 4-radiator; 5-thyristor element; 6-gate assembly; 7-chip packaging assembly; 8-ceramic side wall; 9-lead sleeve; 10-insulating fastener; 11-inner lead; 12-outer lead; 20-lead; 50-first radiator; 60-chip packaging assembly; 70-second radiator; 80-gate assembly; 101-disc spring group; 102-screw rod; 103-insulating sleeve; 104-gasket; 501-first base body; 502-first fin; 601-second packaging shell; 602-silver gasket; 603-cathode molybdenum sheet; 604-chip; 605-anode molybdenum sheet; 606-first packaging shell; 607-red glue; 608-blind hole; 501-first base body; 502-first fin; 701-second base body; 702-second fin; 801-lug plate; 802-second gate member; 803-gate needle; 804-first gate member; 5011-stress separator groove; 6011-cathode copper block; 6012-cathode plastic shell; 6061-anode copper block; 6062-anode plastic shell.

In the accompanying drawings, the same component uses the same reference sign. The accompanying drawings are not drawn to the same scale.

## Detailed Description of the Embodiments

The disclosure will be further described below in conjunction with the accompanying drawings.

As shown in Fig. 4 to Fig. 8, the implementation provides a thyristor element, the thyristor element including a gate assembly 80 and a chip packaging assembly 60. The chip packaging assembly 60 is provided with a blind hole 608 which is at least partially and fixedly connected to the gate assembly 80. The axis of the blind hole 608 is perpendicular to a chip 604 in the chip packaging assembly 60. The gate assembly 80 includes a gate needle 803 extending from the interior of the gate assembly 80 and abutting against a chip gate of the chip; and a lug plate 801 extending out of the top of the gate assembly 80 and configured for connecting the gate needle 803 and a lead 20.

As shown in Figs. 2 and 3, in the existing technique, a gate assembly 6 of the thyristor element 5 is packaged inside a chip packaging assembly 7 thereof, and the use of a lead sleeve 9 penetrating a ceramic side wall 8 is required to connect an inner lead 11 and an outer lead 12, in order to connect a chip gate of a thyristor chip and the outside, where the outer lead 12 and the lead sleeve 9 need to be welded for connection, as shown in Fig. 3. The anti-fatigue capability of welding is relatively weak, which is inconducive to the prolonging of the service life of the thyristor element 5. In addition, the thyristor element 5 in the existing technique is complex in structure, difficult in assembly process and high in production cost, which is inconducive to the promotion and application of the thyristor element 5.

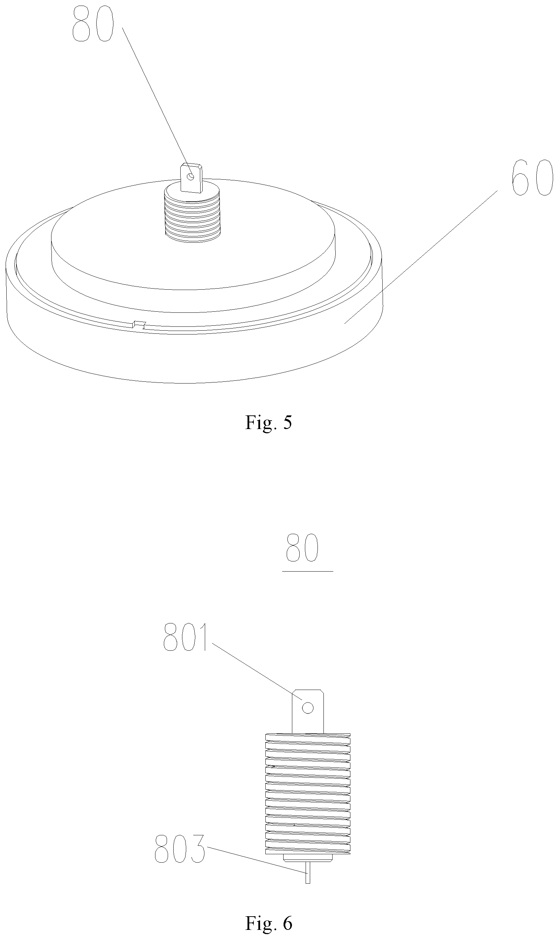

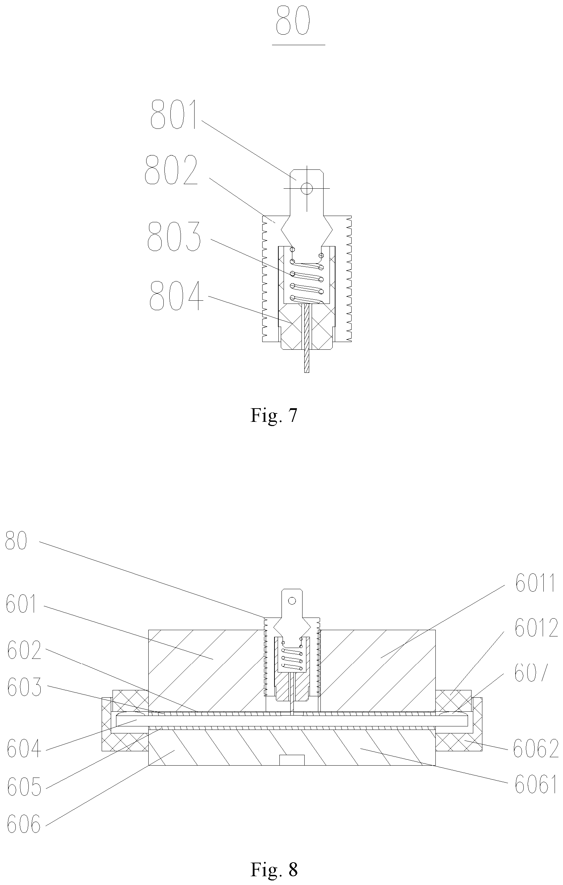

In order to avoid welding and also avoid the lead 20 from penetrating the side wall of the chip packaging assembly 60, the implementation uses the gate assembly 80 as shown in Figs. 6 and 7. The gate assembly 80 includes the gate needle 803 and the lug plate 801, which are fixedly connected to each other. The gate needle 803 directly abuts against the chip gate of the chip 604, and the lead 20 is directly fixedly connected to the lug plate 801, so as to achieve the aim of connecting the lead 20 to the chip gate.

Specifically, the gate needle 803 extends from interior of the gate assembly 80 and abuts against the chip gate of the chip 604 at the bottom of the gate needle. The lug plate 801 extends out of the top of the gate assembly 80 and is configured for connecting the gate needle 803 to the lead 20. The top of the gate assembly 80 is the end of the gate assembly 80 that extends out of an opening of the blind hole 608 on an outer surface of the chip packaging assembly 60, and the bottom of the gate needle 803 is the end of the gate needle 803 that is away from the opening of the blind hole 608 on the outer surface of the chip packaging assembly 60.

The gate assembly 80 is arranged in the blind hole 608 in the chip packaging assembly 60, and the axis of the blind hole 608 is perpendicular to the chip 604 in the chip packaging assembly 60, that is, the axis of the gate assembly 80 is arranged perpendicular to the chip 604. Compared with the lead 20 penetrating the side wall of the chip packaging assembly 60 by using structures such as a lead sleeve, this arrangement has a relatively simple process, because the side wall of a chip packaging assembly 60 in the existing technique is often a ceramic structure, whereas the blind hole 608 in the implementation is provided in the cathode copper block 6011.

In addition, the above-mentioned thyristor element is simple in structure, which is conducive to the miniaturization thereof.

When the lead 20 and the chip gate are connected to each other by using the above-mentioned structure in the implementation, the use of welding is not required, and the lead 20 does not need to penetrate the side wall of the chip packaging assembly 60, which is conducive to the prolonging of the service life of the thyristor element, conducive to the reduction of the production cost of the thyristor element, and also conducive to the decrease of the volume of the thyristor element.

As shown in Fig. 6 to Fig. 8, optionally, the gate assembly 80 in the implementation includes: a gate needle 803 including a needle body and an elastic member, which are integrally formed, with the needle body abutting against a chip gate; a lug plate 801, a first end of which is embedded into an elastic member, and a second end of which is provided with a through-hole for fixing a lead 20; a first gate member 804, where the needle body passes through the first gate member 804 to abut against the chip gate; and a second gate member 802 sleeved outside the first gate member 804 and fixedly engaged in a blind hole 608 of a chip packaging assembly 60 so as to fixedly engage the gate assembly 80 and the chip packaging assembly 60.

The gate assembly 80 connects the lead 20 to the gate chip 604, and has the advantages of a simple manufacturing process, a long service life, stable performance, a low cost, etc., which is conducive to the promotion and application of the gate assembly 80.

Optionally, the diameter of the gate needle 803 is between 0.2 mm and 1.0 mm. When the gate needle 803 is compressed to half of the original length, an elastic force needs to be greater than or equal to 3 N. Firstly, the second gate member 802 and the lug plate 801 are combined into one by using metal insert injection molding process. When the gate assembly 80 is assembled, the gate needle 803 is inserted into a through-hole in the middle part of the first gate member 804, and the first gate member 804 and the second gate member 802, which is fixed to the lug plate 801, are then engaged by means of rotation.

As shown in Fig. 8, optionally, an outer wall of the second gate member 802 in the implementation is at least partially in threaded connection with the side wall of the blind hole 608 of the chip packaging assembly 60.

The outer wall of the second gate member 802 is in threaded connection with the side wall of the blind hole of the chip packaging assembly 60, such that the gate assembly 80 is fixedly connected to the chip packaging assembly 60, which has a good sealing effect, thereby avoiding the chip 604 from being oxidized. In addition, threaded connection is conducive to the quick assembly of the gate assembly 80 and the chip packaging assembly 60, and threads can be easily machined, which is conducive to reducing the cost, thereby facilitating the promotion and application of the thyristor element.

During installation, optionally, a torsion force is controlled between 0.5 Nm and 1.5 Nm, so as to screwing the gate assembly 80 and the chip packaging assembly 60.

As shown in Fig. 7, optionally, the second gate member 802 and the first gate member 804 in the implementation are in interference fit to form a cavity that accommodates an elastic member in a compressed state, and the lug plate 801 passes through the second gate member 802 to be connected to the gate needle 803.

The second gate member 802 and the first gate member 804 are in interference fit, which is conducive to sealing, thereby facilitating avoiding the chip 604 from being oxidized. In order to make the gate needle 803 to abut against the chip gate for ensuring the stable transmission of a signal, it is necessary to compress the length of the gate needle 803 to 1/2 - 3/4 of the original length when the first gate member 804 and the second gate member 802 are connected to each other.

Optionally, the diameter of the cavity in the implementation is greater than the diameter of the elastic member of 0.1mm to 0.3 mm.

Since the diameter of the cavity is greater than the diameter of the elastic member of 0.1 mm to 0.3 mm, the elastic member not being bent and deformed during a compression process can be ensured, which is conducive to the stable transmission of a signal.

As shown in Fig. 4, optionally, the blind hole 608 in the implementation is located in the middle part of the chip packaging assembly 60.

The blind hole 608 is located in the middle part of the chip packaging assembly 60, that is, the gate assembly 80 is located in the middle part of the chip packaging assembly 60, which is conducive to uniform stress distribution, thereby avoiding a local fatigue failure, and facilitating prolonging the service life of the thyristor element.

As shown in Fig. 8, optionally, the chip packaging assembly 60 in the implementation includes a first packaging shell 606 and a second packaging shell 601. The first packaging shell 606 and the second packaging shell 601 enclose a packaging cavity, and an anode molybdenum sheet 605, a chip 604, a cathode molybdenum sheet 603 and a silver gasket 602 are sequentially stacked in the packaging cavity, where the anode molybdenum sheet 605 is in contact with the first packaging shell 601, and the silver gasket 602 is contact with the second packaging shell 601. The gate needle 803 passes through through-holes in the silver gasket 602 and the cathode molybdenum sheet 603 to abut against the chip gate.

There is a relatively large difference between the thermal expansion coefficient of the anode copper block 6061 of the first packaging shell 606 and the cathode copper block 6011 of the second packaging shell 601, and the thermal expansion coefficient of the silicon chip 604, and therefore, the anode molybdenum sheet 605 and the cathode molybdenum sheet 603 are arranged on two sides of the chip 604 in order to avoid the wear of an aluminum layer of the chip 604.

The silver gasket 602 has great extensibility, and therefore, sandwiching the silver gasket 602 as a buffer layer between the cathode molybdenum sheet 603 and the cathode copper block 6011 of the second packaging shell 601, which are different in flatness, is conducive to the stable operation of the thyristor element.

Optionally, the first packaging shell 606, the anode molybdenum sheet 605, the chip 604, the cathode molybdenum sheet 603, the silver gasket 602 and the second packaging shell 601 are sequentially stacked for assembly. After the assembly is completed, the resistance between the gate assembly 80 and the cathode copper block 6011 of the second packaging shell 601 should be between 5 Ω and 40 S2.

The implementation is adaptive to a fully press bonded chip, on both sides of which aluminum was vapor deposited. When the chip is a sintered chip, aluminum is only vapor deposited at the cathode, and therefore, an anode molybdenum sheet can be omit.

A packaging cavity of the chip packaging assembly 60 and the cavity of the gate assembly 80 are in mutual communication. The gate needle 803 passes through the through-holes in the silver gasket 602 and the cathode molybdenum sheet 603 to abut against the chip gate.

The chip packaging assembly 60 in the implementation has the advantages of a simple manufacturing process, a long service life, stable performance, a low cost, etc., which is conducive to the promotion and application of the chip packaging assembly 60.

As shown in Fig. 8, optionally, a first packaging shell 606 in the implementation includes an anode copper block 6061 and an anode plastic shell 6062 surrounding the anode copper block 6061, and a second packaging shell 601 includes a cathode copper block 6011 and a cathode plastic shell 6012 surrounding the cathode copper block 6011, with a blind hole 608 being provided in the middle part of the cathode copper block 6011. Side walls of the blind hole 608 serve as a portion of cavity walls of the packaging cavity.

By using the plastic shell, the reduction of the weight is facilitated, and the reduction of a sealing cost is also facilitated. This is because when the first packaging shell 606 and the second packaging shell 601 are both copper, sealing can be realized only by using a welding process or even a cold welding process. When the cold press welding process is used, the requirement for a device is higher and the packaging process is complex, and the packaging material must be oxygen-free copper, which results in high cost. The anode copper block 6061 and the anode plastic shell 6062 are of an integrated structure and the cathode copper block 6011 and the cathode plastic shell 6012 are of an integrated structure, and therefore, a packaging cavity between the first packaging shell 606 and the second packaging shell 601 can be formed only by means of sealing the anode plastic shell 6062 and the cathode plastic shell 6012. In comparison, the sealing process between the anode plastic shell 6062 and the cathode plastic shell 6012 is simple, and has a low cost.

The blind hole 608 is provided in the middle part of the cathode copper block 6011, that is, the gate assembly 80 is located in the middle part of the cathode copper block 6011, which is conducive to uniform stress distribution, thereby avoiding a local fatigue failure, and facilitating prolonging the service life of the thyristor element.

Optionally, the first packaging shell 606 and the second packaging shell 601 in the implementation are both formed by using metal insert injection molding process.

The metal insert injection molding process is a mature process that is widely used, and is conducive to the reduction of the manufacturing cost of the first packaging shell 606 and the second packaging shell 601.

Optionally, the chip packaging assembly 60 in the implementation packages the chip 604 by using a solid sealing dielectric, and the first packaging shell 606 is provided with a glue injection opening.

A liquid sealing dielectric can enter the sealing cavity through the glue injection opening, and after being cured, the liquid sealing dielectric becomes solid. Optionally, the liquid sealing dielectric needs to immerse the cathode molybdenum sheet 603, so as to avoid the chip 604 from being oxidized.

Optionally, the above-mentioned structure can also use nitrogen filling, but then the requirement for its sealing performance is higher, and a leakage detection test is required after packaging. In order to ensure the sealing performance, it is generally necessary to use a press welding process for sealing, where the process is complex and the maintenance cost of the device is high. In order to use the press welding process, it is also necessary to use the first packaging shell 606 and the second packaging shell 601 that are made of oxygen-free copper. The cost of the oxygen-free copper is much higher than that of red copper. In addition, as nitrogen is a gas, the storage and transportation thereof also increase the cost of a product.

Since the solid sealing dielectric is used, the cathode copper block 6011 and the anode copper block 6061 may be made of red copper, the press welding process is not required, and a leakage detection test is also not required after the sealing, such that the cost of the product can be greatly reduced.

Optionally, the solid sealing dielectric in the implementation is silica gel.

The silica gel is a common industrial material, can be conveniently used and has a low cost. Using the silica gel as the solid sealing dielectric is conducive to reducing the cost.

Optionally, when the silica gel in the implementation is liquid, the viscosity thereof is between 500 mPa s and 800 mPa s, and after the silica gel is cured, the dielectric strength thereof is 12 kV/mm.

The excessively high viscosity of silica gel is inconducive to the silica gel entering a narrow and small slit, while the excessively low viscosity of silica gel is inconducive to the smooth proceeding of subsequent curing, and therefore, the viscosity of the silica gel needs to be controlled between 500 mPa·s and 800 mPa·s.

The stronger the dielectric strength of the silica gel is, the harder same is to be broken through, and the more conducive same is to the improvement of the high voltage resistance of the thyristor element. However, when the dielectric strength of the silica gel exceeds a certain value, the cost thereof will greatly increase. Therefore, the dielectric strength of the cured silica gel reaching 12 kV/mm can satisfy the design requirement.

Optionally, liquid silica gel is formed by mixing two components of silica gel at a ratio of 1 : 1.

In addition, the used liquid silica gel will not react chemically with the red glue 607 that is used for protecting the chip 604. In order to avoid the occurrence of a chemical reaction, it is necessary to test pre-selected silica gel before the first instance of packaging. During the test, the chip 604 is immersed in the pre-selected liquid silica gel first, the liquid silica gel is then cured, and observation is made after the curing. If it is observed that floccule or liquid appears at the edge of the red glue 607, it can be determined that the red glue 607 reacts chemically with the silica gel under test, and the silica gel under test cannot be used.

Optionally, the main parameters of a silica gel injection sealing process are: the vacuum degree of the cavity being -0.06 MPa to 0.08 MPa; the time for vacuum defoaming being 5 min to 8 min; the curing temperature being 130±5°C; and the time for curing being 60 min.

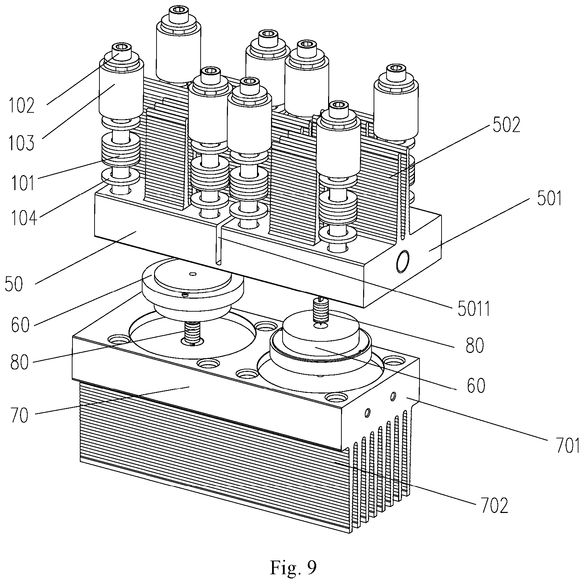

As shown in Fig. 9, the implementation further provides a thyristor element assembly structure, the thyristor element assembly structure including a first radiator 50, a second radiator 70 and the above-mentioned thyristor element sandwiched between the first radiator 50 and the second radiator 70.

The thyristor element assembly structure of the implementation includes two radiators respectively located on two sides of the thyristor element, and compared with arranging a radiator merely on one side of the thyristor element, it is conducive to improving the radiation capability of the thyristor element assembly structure, so that same is adapted to the soft start of an electric motor the power of which is greater than 100 kW.

The thyristor element assembly structure of the implementation uses the above-mentioned thyristor element, such that welding can be avoided, and the lead 20 can also be avoided from penetrating a side wall of the chip packaging assembly 60, which is conducive to the prolonging of the service life of the thyristor element, conducive to the reduction of the production cost of the thyristor element, and also conducive to the decrease of the volume of the thyristor element.

In order to satisfy the requirements of different conditions for a creepage distance, the vertical spacing between the first radiator 50 and the second radiator 70 is a key size for measuring whether the assembly is qualified.

As shown in Fig. 9 to Fig. 11, optionally, the first radiator 50 and the second radiator 70 of the implementation are fixedly connected by means of four insulating fasteners 10, with the insulating fastener 10 including: a screw rod 102, which passes through the first radiator 50 to be in a threaded fit with a threaded hole of the second radiator 70; an insulating sleeve 103 sleeved on the screw rod 102; a disc spring group 101 sleeved outside the insulating sleeve 103 and located between the first radiator 50 and the insulating sleeve 103; and gaskets 104 sleeved on the insulating sleeve 103 and arranged at two ends of the disc spring group 101.

In addition, the insulating fastener 10 in the implementation can ensure that the first radiator 50 and the second radiator 70 are in an electrical isolation state while fixing the first radiator 50 and the second radiator 70, thereby avoiding the occurrence of a short circuit.

The function of the screw rod 102 is for fixedly connecting the first radiator 50 to the second radiator 70, and the screw rod 102 includes a head part and a rod-shaped main body. The rod-shaped main body extends from the first radiator 50 to the second radiator 70 and is in threaded fit with the second radiator 70. Optionally, the head part of the screw rod 102 is provided with an inner hexagon countersink, such that the mounting process requires less time and labor. The implementation does not limit the strength of threads of the second radiator 70. Optionally, in order to adjust the strength of threads, a wire thread insert assembly process can be used. When a wire thread insert is used, lubricating oil can be applied in order to avoid the occurrence of phenomenon such as the bonding and seizure of threads.

The insulating sleeve 103 sleeved on the screw rod 102 is mainly used for electrically isolating the first radiator 50 from the second radiator 70.

As shown in Fig. 9 to Fig. 11, the disc spring group 101 is sleeved outside the insulating sleeve 103, and therefore, the size of the diameter of a disc spring is not limited by the size of the inner diameter of the insulating sleeve 103, and the size of the disc spring can be freely adjusted according to a required disc spring load, thereby facilitating the optimization of the ratio of the disc spring quantity to the diameter of the disc spring. The function of the disc spring group 101 is for damping, so as to prolong the service life of the thyristor element assembly structure.

Optionally, according to the requirements for deformation and load, the implementation discloses a feasible combination method for a disc spring group 101. The combination method comprises firstly dividing a plurality of disc springs into two groups, superimposing (connecting in parallel) all the disc springs in each disc group, and then aligning (connecting in series) the two groups. Optionally, each disc spring group is composed of five superimposed disc springs, that is, each insulating fastener 10 includes ten disc springs.

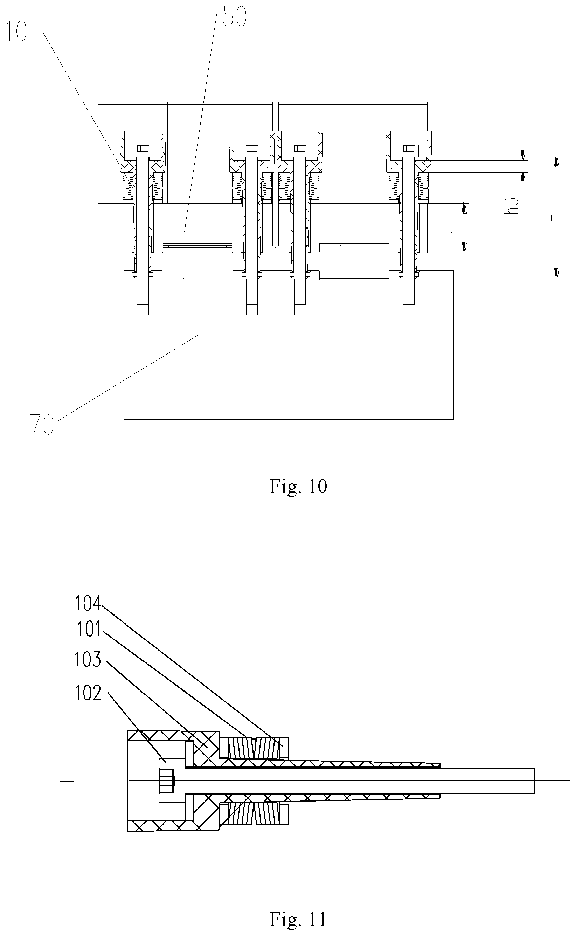

Optionally, when the size of a disc spring is designed, it is also necessary to take the axial expansion of a related part after being heated into consideration. Optionally, for the thyristor element assembly structure of the implementation, the highest working temperature is 130°C, and the normal temperature is 30°C. As shown in Fig. 10, the thickness of the first base body 501 of the first radiator 50 is hi, the working length of the screw rod 102 is L, and the distance between the first sleeve body of the insulating sleeve 103 and the second sleeve body thereof is $h_3$. According to the following thermal deformation formula:

$$\sigma = \rho * H * \Delta T,$$

When the material of the first base body 501 is a 6 series aluminum alloy (the density: $23.8 * 10^{-6}/°C$) and the material of the screw rod 102 is carbon steel (the density: $11.5 * 10^{-6}/°C$), it can be obtained that:

the axial deformation $\sigma^{h1}$ of the first base body 501 is $23.8 * 10^{-4} * hi$; and
the axial deformation $\sigma^{L}$ of the screw rod 102 is $11.5 * 10^{-4} * L$.

In addition, the axial deformation $\sigma^{h3}$ of the insulating sleeve 103 is about $h_3/80$, and at this time, the material of the insulating sleeve 103 is polyethylene terephthalate (referred to as "PET" for short) with the addition of 35-55% glass fiber or polyphenylene sulfide (referred to as "PPS" for short) with the addition of 35-55% glass fiber, and the pressure applied to a single insulating sleeve 103 is about 15 kN.

In this way, it is obtained that the required actual deformation amount x should satisfy $x \geq \Delta t + \sigma h_3 + \sigma L - \sigma hi$, where $\Delta t$ refers to the deformation of a single disc spring when heating is not taken into consideration.

The gaskets 104 are sleeved on the insulating sleeve and are located at two ends of the disc spring group 101. Since the gaskets 104 have great extensibility, same can have the function of buffering, thereby prolonging the service life of the disc spring group 101.

Optionally, the first radiator 50 and the second radiator 70 of the implementation are fixedly connected by means of four insulating fasteners 10. An existing thyristor element assembly structure includes at least one thyristor element, where each thyristor element uses two existing insulating fasteners 10 to connect the first radiator 50 and the second radiator 70 on two sides of the thyristor element, and therefore, it is necessary to configure a leveling apparatus, such as a steel ball. The use of a leveling apparatus is inconducive to the reduction of a component quantity, and the reduction of the volume and the weight of the thyristor element assembly structure. In the implementation, since each thyristor element uses four insulating fasteners 10 mentioned above to connect the first radiator 50 and the second radiator 70 on two sides of the thyristor element, a height difference caused by tolerances of various components can be eliminated even if no leveling apparatus is used, thereby ensuring uniform pressure distribution.

As shown in Fig. 9 to Fig. 11, optionally, the insulating sleeve 103 of the implementation is an integrated sleeve, the insulating sleeve 103 includes a first sleeve body and a second sleeve body, which are in communication with each other, the diameter of the first sleeve body is greater diameter of the second sleeve body, the first sleeve body is configured for accommodating the head part of screw rod 102, and the second sleeve body is configured for accommodating a part of a main body of the screw rod and extends from first radiator 50 to the second radiator 70.

The integrated sleeve is conducive to improving a high voltage resistance level and the mechanical pressure resistance of the insulating fastener 10. A soft starter that uses an integrated sleeve can withstand a voltage up to 6500 V.

Optionally, the insulating sleeve 103 of the implementation includes a first sleeve body and a second sleeve body, which are separated from each other, the first sleeve body is located between the main body of the screw rod 102 and the first radiator 50, and the second sleeve body is located between the main body of the screw rod 102 and the second radiator 70.

The first sleeve body and the second sleeve body that are separated from each other are conducive to reducing the production and mounting costs. However, a soft starter that uses the first sleeve body and the second sleeve body that are separated from each other is merely adapted to a voltage under 1800 V. When the voltage is higher than 1800 V, the safe use cannot be realized.

Optionally, the insulating sleeve 103 is made of a material the comparative tracking index of which is less than or equal to 400, thereby facilitating the safe use of the thyristor element assembly structure.

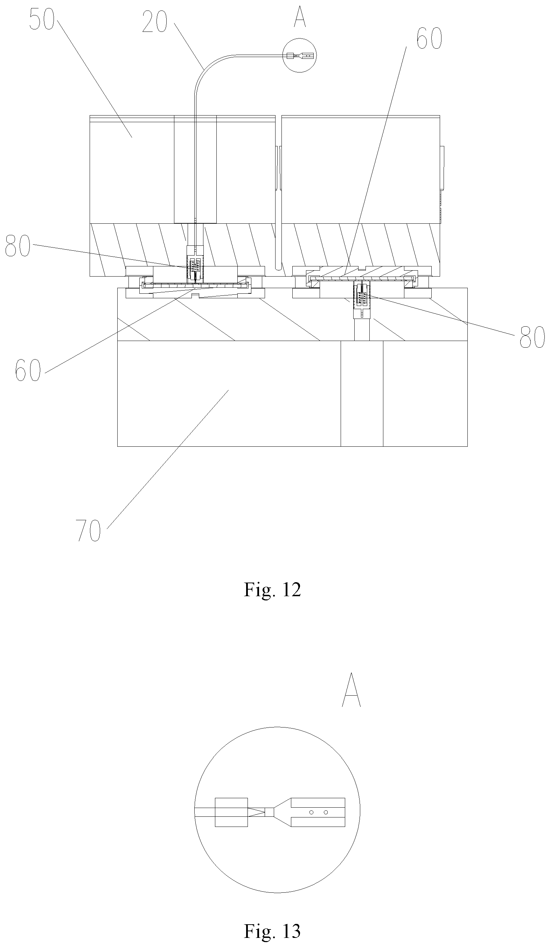

As shown in Figs. 9 and 12, optionally, the thyristor element assembly structure of the implementation includes two thyristor elements, which are connected in antiparallel, and two first radiators 50, which correspond to the thyristor elements on a one-to-one basis.

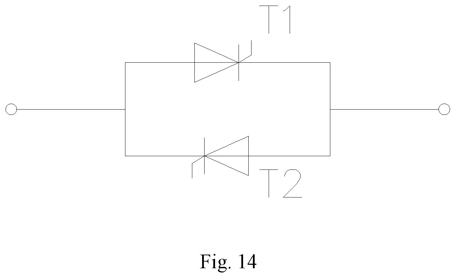

The thyristor element assembly structure of the implementation includes two thyristor elements, which are connected in antiparallel, and Fig. 14 shows the circuit topology graph thereof. As shown in Fig. 9, the two first radiators 50 of the implementation are integrated. In the existing technique, when two first radiators 50 are separated from each other, it is still necessary to connect the two first radiators 50 in series by using a connection copper busbar in order to realize the antiparallel topology structure of the thyristor element. The two radiators, as whole, play a role in connecting the two thyristor elements, and the use of an external copper busbar is not required for connection, such that the material cost and the volume of the thyristor element assembly structure can be reduced, so as to facilitate the miniaturization of the soft starter, thereby improving the market competitiveness of the soft starter.

As shown in Fig. 9, optionally, the two first radiators 50 of the implementation form an integral radiator by means of a stress separator groove 5011 provided therebetween.

Due to the limitations of the mechanical machining precision and cost, two thyristor elements, in particular two thyristor elements from different production batches, will have a height difference. Moreover, it is not possible to ensure a contact plane of a radiator and a thyristor element being absolutely flat, and it is also not possible to ensure the height of the radiator being consistent. It is not possible that the sum of the height of the thyristor element and the height of the radiators on two sides thereof maintains consistent. There is generally a difference of 20 $\mu$m to 50 $\mu$m.

When a pressure machine applies a pressure to fix a thyristor element assembly structure, due to the height difference, a pressure stress that is vertically downward may generate interference. In order to avoid the pressure interference and to prolong the service life of a product, a stress separator groove 5011 is provided between two first radiators 50. The pressure machine applying a pressure for fixation is to ensure great electrical contact between various layers of the thyristor element assembly structure.

As shown in Fig. 9, optionally, the first radiator 50 of the implementation includes first base bodies 501 and a plurality of first fins 502, with the stress separator groove 5011 being provided between two first base bodies 501; and the second radiator 70 includes second base bodies 701 and a plurality of second fins 702.

The sizes of the stress separator groove 5011 corresponding to different pressures under different conditions are between 1.5 mm and 4.0 mm, and the thickness of the cut first base body 501 is between 2 mm and 30 mm. The two first radiators 50 that are provided with the stress separator groove 5011, as a whole, can still withstand a short-time overcurrent of 1000-7500 A.

By means of increasing the surface area, the fins are conducive to improving the radiation capability of a radiator. As shown in Fig. 9, the first fin 502 needs to be arranged avoiding the stress separator groove 5011 and the insulating fastener 10.

Optionally, in order to further optimize the radiation capability of the first radiator 50 and the second radiator 70, a simulated analysis can be performed according to a power level of the thyristor element, so as to determine the specific sizes of the base body and the fin, such as the fin quantity, the length-to-height ratio of the fin, the size of the fin and the size of the base body.

The implementation further provides a soft starter, the soft starter including the above-mentioned thyristor element assembly structure.

As shown in Figs. 12 and 13, a first end of a lead 20 of a soft starter is fixedly connected to a gate assembly 80, and a second end of the lead 20 is fixed with a standard plugging member, so that the gate assembly 80 is connected to a trigger control panel of the soft starter by means of the lead 20. Fig. 13 is a locally enlarged diagram which shows the specific structure of the plugging member.

The soft starter of the implementation uses a thyristor element assembly structure that has the above-mentioned thyristor element, and the use of welding is not required and a lead does not need to penetrate a side wall of a chip packaging assembly, which is conducive to prolonging the service life of the soft starter, conducive to reducing the production cost of the soft starter, also conducive to the miniaturization of the soft starter, and thus conducive to the soft starter gaining market approbation.

In the description of the present invention, it is to be understood that the terms of "above", "below", "bottom", "top", "front", "rear", "inside", "outside", "left", "right", etc. indicating orientation or position relationships are based on the orientation or position relationship shown in the accompanying drawings and are intended to facilitate the description of the present invention and simplify the description only, rather than indicating or implying that an apparatus or element referred to must have a particular orientation or be constructed and operated in a particular orientation, and will not to be interpreted as limiting the invention.

Although the invention is described herein with reference to particular implementations, it should be understood that these embodiments are merely examples for the principle and application of the invention. Therefore, it should be understood that many modifications can be made to the exemplary embodiments, and other arrangements can be designed, without departing from the scope of the invention defined by the appended claims. It should be understood that the features in different dependent claims and the features described herein can be combined in a manner different from that described by the original claims. It can also be understood that the features described in conjunction with a single embodiment can be used in other embodiments.

**Claims**

1. A thyristor element assembly structure, **characterized by** comprising a first radiator (50), a second radiator (70) and a thyristor element (5) sandwiched between the first radiator and the second radiator, wherein the thyristor element (5) is connected with the first radiator (50) and the second radiator (70) that are on both sides of the thyristor element by means of a plurality of insulating fasteners (10), the thyristor element (5) comprises a gate assembly (80) and a chip packaging assembly (60), the chip packaging assembly (60) comprises a first packaging shell (606) and a second packaging shell (601), the first packaging shell and the second packaging shell enclose a packaging cavity, the second packaging shell (601) is provided with a blind hole (608) which is at least partially and fixedly connected to the gate assembly, side walls of the blind hole (608) serve as a portion of cavity walls of the packaging cavity, the axis of the blind hole is perpendicular to a chip (604) in the chip packaging assembly, the gate assembly comprising:

   a gate needle (803) extending from the interior of the gate assembly and abutting against a chip gate of the chip;
   a lug plate (801) extending out of the top of the gate assembly and configured for connecting the gate needle and a lead;
   a first gate member (804), wherein the needle body passes through the first gate member to abut against the chip gate; and
   a second gate member (802) sleeved outside the first gate member and fixedly engaged in the blind hole (608) of the chip packaging assembly so as to fixedly engage the gate assembly and the chip packaging assembly.

2. The thyristor element assembly structure according to claim 1, **characterized in that** the gate assembly comprises:

   the gate needle comprising a needle body and an elastic member, which are integrally formed, with the needle body abutting against the chip gate;

the lug plate, a first end of which is embedded into the elastic member, and a second end of which is provided with a through-hole for fixing the lead,

wherein the second gate member (802) and the first gate member (804) are in interference fit to form a cavity that accommodates the elastic member in a compressed state, and the lug plate (801) passes through the second gate member to be connected to the gate needle.

3. The thyristor element assembly structure according to claim 1, **characterized in that** an anode molybdenum sheet (605), the chip (604), a cathode molybdenum sheet (603) and a silver gasket (602) are sequentially stacked in the packaging cavity, wherein the anode molybdenum sheet is in contact with the first packaging shell (606), and the silver gasket is contact with the second packaging shell (601); and the gate needle passes through through-holes in the silver gasket and the cathode molybdenum sheet to abut against the chip gate.

4. The thyristor element assembly structure according to claim 3, **characterized in that** the first packaging shell (606) comprises an anode copper block (6061) and an anode plastic shell (6062) surrounding the anode copper block, and the second packaging shell (601) comprises a cathode copper block (6011) and a cathode plastic shell (6012) surrounding the cathode copper block, with the blind hole (608) being provided in the middle part of the cathode copper block (6011).

5. The thyristor element assembly structure according to claim 3, **characterized in that** the first packaging shell (606) and the second packaging shell (601) are both formed by using metal insert injection molding process.

6. The thyristor element assembly structure according to claim 3, **characterized in that** the chip packaging assembly (60) packages the chip (604) by using a solid sealing dielectric, and the first packaging shell (606) is provided with a glue injection opening.

7. The thyristor element assembly structure according to claim 6, **characterized in that** the solid sealing dielectric is silica gel.

8. The thyristor element assembly structure according to claim 7, **characterized in that**, when the silica gel is liquid, the viscosity thereof is between 500 mPa s and 800 mPa·s; and after the silica gel is cured, the dielectric strength thereof is 12 kV/mm.

9. The thyristor element assembly structure according to claim 1, **characterized in that** the first radiator (50) and the second radiator (70) are fixedly connected by means of four insulating fasteners (10), with the insulating fastener comprising:

a screw rod (102), which passes through the first radiator to be in threaded fit with a threaded hole of the second radiator;
an insulating sleeve sleeved (103) on the screw rod;
a disc spring group (101) sleeved outside the insulating sleeve and located between the first radiator and the insulating sleeve; and
gaskets (104) sleeved on the insulating sleeve and arranged at two ends of the disc spring group.

10. The thyristor element assembly structure according to claim 9, **characterized in that** the insulating sleeve (103) is an integrated sleeve, the insulating sleeve comprises a first sleeve body and a second sleeve body, which are in communication with each other, the diameter of the first sleeve body is greater than the diameter of the second sleeve body, the first sleeve body is configured for accommodating the head part of the screw rod, and the second sleeve body is configured for accommodating part of a main body of the screw rod and extends from the first radiator (50) to the second radiator (70).

11. The thyristor element assembly structure according to claim 9, **characterized in that** the insulating sleeve (103) comprises a first sleeve body and a second sleeve body, which are separated from each other, the first sleeve body is located between the main body of the screw rod (102) and the first radiator (50), and the second sleeve body is located between the main body of the screw rod (102) and the second radiator (70).

12. The thyristor element assembly structure according to claim 9, **characterized in that** the insulating sleeve is made of a material the comparative tracking index of which is less than or equal to 400.

13. The thyristor element assembly structure according to claim 13 or 14, **characterized by** comprising two thyristor elements, which are connected in antiparallel, and two first radiators, which correspond to the thyristor elements on a one-to-one basis.

14. The thyristor element assembly structure according to claim 13, **characterized in that** the two first radiators (50) form an integral radiator by means of a stress separator groove (5011) provided therebetween.

**15.** The thyristor element assembly structure according to claim 14, **characterized in that** the first radiator (50) comprises first base bodies (501) and a plurality of first fins (502), with the stress separator groove (5011) being provided between two first base bodies; and the second radiator (70) comprises second base bodies (701) and a plurality of second fins (702).

4

3

2

1

Fig. 1

4

4

12

5

4

Fig. 2

5

Fig. 3

Fig. 4

Fig. 5

Fig. 6

80

801

802

803

804

Fig. 7

80

601

602

603

604

605

606

6011

6012

607

6062

6061

Fig. 8

Fig. 9

Fig. 10

Fig. 11

Fig. 12

Fig. 13

Fig. 14